# EUROPÄISCHE PATENTSCHRIFT

(11) **EP 4 005 033 B1**
(45) Veröffentlichungstag und Bekanntmachung des Hinweises auf die Patenterteilung: **22.05.2024**
(21) Anmeldenummer: 20734359.1
(22) Anmeldetag: 22.06.2020
(51) Int. Cl.: H01R 13/652

(54) **STECKVERBINDER MIT ISOLATIONSÜBERWACHUNG**
PLUG CONNECTOR HAVING INSULATION MONITORING
CONNECTEUR MÂLE AVEC SURVEILLANCE D'ISOLATION

(30) Priorität: 30.07.2019 DE 102019120470
(43) Veröffentlichungstag der Anmeldung: 01.06.2022
(73) Patentinhaber: Phoenix Contact e-Mobility GmbH, 32816 Schieder-Schwalenberg (DE)
(72) Erfinder: FÜHRER, Thomas, 32825 Blomberg (DE)
(74) Vertreter: Meyer-Graefe, Karsten
(86) Internationale Anmeldenummer: PCT/EP2020/067279
(87) Internationale Veröffentlichungsnummer: WO 2021/018475

(56) Entgegenhaltungen:
- DE-A1-102016 105 311
- FR-A1- 3 041 172
- US-A1- 2016 118 744

## Beschreibung

Die Erfindung betrifft ein Steckverbinderteil zur elektrischen Verbindung mit einem Gegensteckverbinderteil, mit einem Gehäuse, zumindest zwei Lastkontakten, einem elektrisch isolierenden Kontaktträger, durch den die Lastkontakte am Gehäuse gehalten sind, einem Schutzleiterkontakt und einem Erdungselement, das im Gehäuse angeordnet ist und elektrisch mit dem Schutzleiterkontakt verbunden ist. Dabei ist vorgesehen, dass sich das Erdungselement zumindest abschnittsweise (z.B. durch Feuchtigkeit, insbesondere eindringendes Wasser) elektrisch kontaktierbar an einem Kriechpfad zwischen den beiden Lastkontakten erstreckt. Weiter betrifft die Erfindung eine Ladeanordnung zum Be- und/oder Entladen eines Elektrofahrzeugs und ein Elektrofahrzeug.

Insbesondere im Bereich der E-Mobilität bestehen für Steckverbinderteile und damit verbundene Ladekabel besonders hohe Anforderungen hinsichtlich ihrer funktionalen Leistungsfähigkeit, Stabilität und Sicherheit. Insbesondere bei möglichen Gleichstrom-Ladeströmen, z.B. bis zu 500 A mit Ladespannungen bis zu 1000 V, ist es wünschenswert, dass auch bei mehrjährigem Gebrauch mit einer Vielzahl an Ladezyklen die Leistungsfähigkeit der Steckverbinderteile aufrechterhalten wird.

Eine potentielle Gefahrenquelle können bei Steckverbinderteilen allgemein Baugruppen darstellen, die hohe Spannungen führen und Umwelteinflüssen ausgesetzt sind. Bei solchen Baugruppen besteht ein Risiko, dass sich durch Beschädigungen von Gehäusebauteilen Undichtigkeiten ergeben, die einen Eintritt von Feuchtigkeit in das Innere des Steckverbinderteils an eine der genannten Baugruppen erlauben. Im Bereich der E-Mobilität kommt erschwerend die Möglichkeit einer Verschmutzung durch Salzwasser hinzu, also durch einen gut leitfähigen Elektrolyten. Derart eingedrungene Feuchtigkeit kann zu einer Verschlechterung der Isolation oder gar zu deren Versagen, z.B. durch Lichtbogenbildung, führen.

Die DE 10 2016 105 311 A1 beschreibt ein Steckverbinderteil mit einem Kontakthalter, der einen Grundkörper aufweist, welcher mit einer elektrisch isolierenden Ummantelung versehen ist.

Aufgabe der vorliegenden Erfindung ist es, ein möglichst sicheres Steckverbinderteil bereitzustellen.

Diese Aufgabe wird durch einen Gegenstand mit den Merkmalen des Anspruchs 1 gelöst.

Danach wird ein Steckverbinderteil zur Verfügung gestellt, welches sich dadurch auszeichnet, dass das Erdungselement ein Messer umfasst, das eine Öffnung im Kontaktträger durchgreift.

Ein derartiges Steckverbinderteil ermöglicht eine Isolationsüberwachung zwischen den Lastkontakten, wodurch die Sicherheit, insbesondere gegenüber einer Lichtbogenbildung, deutlich erhöht werden kann. Bei dem Steckverbinderteil kann es sich z.B. um eine Fahrzeugladedose oder um einen Ladestecker (z.B. von einer Ladesäule) handeln.

Das Erdungselement kann sich insbesondere elektrisch kontaktierbar zumindest abschnittsweise an dem kürzesten Kriechpfad zwischen den beiden Lastkontakten erstrecken. Hierbei kann der Kriechpfad überwacht werden, an dem ein vergleichsweise hohes Risiko einer fehlerhaften Isolation besteht.

Optional erstreckt sich das Erdungselement zumindest abschnittsweise räumlich zwischen den Lastkontakten. Hierdurch ist eine besonders sichere Isolationsüberwachung möglich.

Erfindungsgemäß umfasst das Steckverbinderteil einen elektrisch isolierenden Kontaktträger, durch den die Lastkontakte am Gehäuse gehalten sind. Das ermöglicht eine einfache Montage und sichere Halterung der Lastkontakte.

Weiter erfindungsgemäß umfasst das Erdungselement einen vorstehenden, z.B. flachen Abschnitt, in Form eines Messers. Dabei kann der vorstehende Abschnitt, z.B. ein Vorsprung bzw. das Messer, eine Öffnung im Kontaktträger durchgreifen. Hierdurch kann mit dem Erdungselement besonders sicher die Isolation der Lastkontakte überwacht werden.

Optional umfasst der Kontaktträger für jeden der Lastkontakte eine Isolationskontur. Dabei kann vorgesehen sein, dass sich das Messer des Erdungselements zumindest abschnittsweise zwischen den Isolationskonturen erstreckt.

Gemäß einer Ausgestaltung umfasst das Steckverbinderteil einen Steckkörper, der für jeden der Lastkontakte eine Isolationskontur aufweist. Jede der Isolationskonturen des Steckkörpers kann mit der Isolationskontur des Kontaktträgers für den jeweiligen Lastkontakt in Eingriff stehen. Das ermöglicht eine Verlängerung des Kriechpfades, an welchem das Messer des Erdungselements angeordnet ist.

Der Kontaktträger kann für jeden Lastkontakt einen Schirmabschnitt zur elektrischen Isolation vom jeweils anderen Lastkontakt aufweisen, was eine besonders sichere Isolation ermöglicht.

Das Erdungselement kann sich in einer Weiterbildung zumindest abschnittsweise zwischen den Schirmabschnitten und/oder zumindest abschnittsweise um die Schirmabschnitte herum erstrecken, um eine Isolationsüberwachung weiter zu verbessern.

Zumindest ein Teil des Erdungselements kann sich bei einer bestimmungsgemäßen Verbindung des Steckverbinderteils mit dem Gegensteckverbinderteil an einer weiter unten gelegenen Stelle erstrecken als die Lastkontakte. Falls Wasser in das Gehäuse eindringen kann, dann sammelt sich das Wasser in einem unteren Bereich. Durch Anordnung des Erdungselements näher an diesem Bereich als die Lastkontakte kann die Sicherheit der Isolationsüberwachung weiter gesteigert werden.

Optional umfasst das Erdungselement einen insbesondere metallischen, elektrisch leitfähigen Körper.

Der (insbesondere metallische) Körper kann über ein Kabel mit dem Schutzleiterkontakt elektrisch verbunden sein, was eine besonders flexible und damit für die Isolationsüberwachung optimale Anordnung des Körpers erlaubt.

Bei dem Steckverbinderteil kann es sich um ein Hochstrom- und/oder Hochspannungs-Steckverbinderteil handeln. Beispielsweise ist das Steckverbinderteil dazu ausgebildet, eine elektrische Leistung von 10 kW oder mehr zu leiten, insbesondere von 50 kW oder mehr, 135 kW oder mehr, oder 350 kW oder mehr. Beispielsweise ist das Steckverbinderteil dazu ausgebildet, elektrische Ströme mit Stromstärken von 100A oder mehr, 200A oder mehr, 300 A oder mehr, insbesondere von 500 A oder mehr zu leiten.

Das Steckverbinderteil kann als Fahrzeugladestecker ausgebildet sein, insbesondere zum Gleichstrom-Hochstrom laden.

Gemäß einem Aspekt wird eine Ladeanordnung zum Be- und/oder Entladen eines Elektrofahrzeugs bereitgestellt, die das Steckverbinderteil nach einer beliebigen, hierin beschriebenen Ausgestaltung umfasst und eine elektrisch mit dem Schutzleiterkontakt des Steckverbinderteils verbundene oder verbindbare Isolationsüberwachungseinrichtung. Die Isolationsüberwachungseinrichtung ist z.B. dazu eingerichtet, eine am Schutzleiterkontakt anliegende elektrische Spannung gegenüber einem Erdpotential zu erfassen, z.B. vor Einleiten eines Ladevorgangs. Die Ladeanordnung ist z.B. Teil eines Fahrzeugs oder einer stationären, an ein Stromnetz angeschlossenen Ladestation.

Gemäß einem Aspekt wird ein Elektrofahrzeug bereitgestellt, das das Steckverbinderteil nach einer beliebigen, hierin beschriebenen Ausgestaltung und/oder die Ladeanordnung nach einer beliebigen, hierin beschriebenen Ausgestaltung umfasst.

Der der Erfindung zugrunde liegende Gedanke soll nachfolgend anhand von in den Figuren dargestellten Ausführungsbeispielen näher erläutert werden. Es zeigen:
- Fig. 1: eine Ansicht eines Fahrzeugs mit einem Steckverbinderteil und einer Ladestation mit einem Gegensteckverbinderteil;
- Fig. 2 und 3: Ansichten des Steckverbinderteils gemäß Fig. 1 mit einem Gehäuse und einem Steckkörper und mit daran angeschlossenen Kabeln;
- Fig. 4: eine Ansicht des Steckkörpers und weiteren Teilen des Steckverbinderteils gemäß Fig. 2 und 3;
- Fig. 5: eine Ansicht eines Kontaktträgers mit daran gehaltenen Lastkontakten, eines Erdungselements und eines Schutzleiterkontakts des Steckverbinderteils gemäß Fig. 2 und 3;
- Fig. 6: eine Ansicht des Kontaktträgers mit den daran gehaltenen Lastkontakten und des Erdungselements des Steckverbinderteils gemäß Fig. 2 und 3;
- Fig. 7: eine Explosionsansicht der in Fig. 6 gezeigten Komponenten des Steckverbinderteils gemäß Fig. 2 und 3;
- Fig. 8 und 9: Ansichten des Kontaktträgers und des Erdungselements des Steckverbinderteils gemäß Fig. 2 und 3;
- Fig. 10 und 11: Ansichten eines Gehäuseteils mit dem daran montierten Steckkörper des Steckverbinderteils gemäß Fig. 2 und 3; und
- Fig. 12 und 13: Querschnittsansichten des Steckverbinderteils gemäß Fig. 2 und 3.

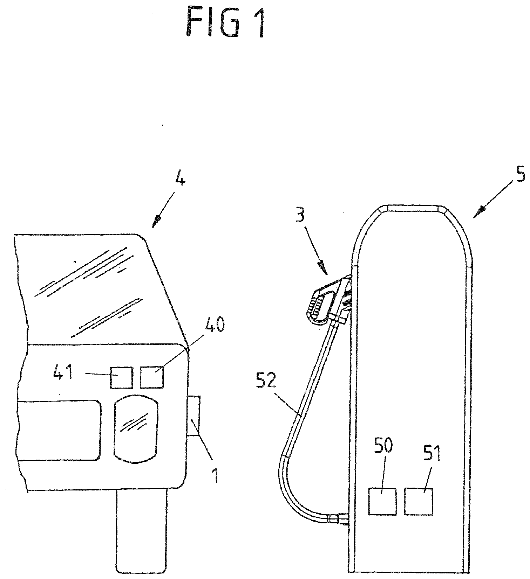

Fig. 1 zeigt ein elektrisch angetriebenes Fahrzeug 4, auch bezeichnet als Elektrofahrzeug, mit einem Steckverbinderteil 1, hier in Form einer Ladebuchse, zur lösbaren elektrischen Verbindung mit einem Gegensteckverbinderteil 3. Gemeinsam bilden das Steckverbinderteil 1 und das Gegensteckverbinderteil 3 einen Steckverbinder. Ferner zeigt Fig. 1 eine Ladestation 5, die zum Aufladen des Fahrzeugs 4 dient. Die Ladestation 5 ist dazu ausgestaltet, einen Ladestrom in Form eines Gleichstroms (alternativ oder zusätzlich eines Wechselstroms) zur Verfügung zu stellen und ist über ein Kabel 52 mit dem Gegensteckverbinderteil 3 in Form eines Ladesteckers verbunden. Das Gegensteckverbinderteil 3 ist im gezeigten Beispiel als manuell betätigbarer Ladestecker für das Elektrofahrzeug 4 ausgebildet.

Die Ladestation 5 umfasst im gezeigten Beispiel ferner eine Ladeeinrichtung 50 (in Form einer DC-Ladeeinrichtung) zum Laden des Fahrzeugs 4 mit Gleichstrom und/oder zum Aufnehmen von durch das Fahrzeug 4 bereitgestelltem Gleichstrom. Darüber hinaus umfasst die Ladestation 5 eine (optionale) Isolationsüberwachungseinrichtung 51. Die Isolationsüberwachungseinrichtung 51 ist dazu ausgebildet, ein an einem Schutzleiter (Protective Earth, PE-Leiter) anliegendes Potential zu erkennen und/oder einen elektrischen Widerstand zwischen einem Lastkontakt und dem PE-Leiter zu messen.

Das Fahrzeug 4 umfasst typischerweise eine Ladeeinrichtung 40 (in Form einer DC-Ladeeinrichtung), welche dazu ausgebildet ist, eine Traktionsbatterie des Fahrzeugs 4 mittels des am Steckverbinderteil 1 bereitgestellten Gleichstroms zu laden und/oder um in der Traktionsbatterie gespeicherte Energie als Gleichstrom über das Steckverbinderteil 1 bereitzustellen. Ferner umfasst das Fahrzeug 4 eine (optionale) Isolationsüberwachungseinrichtung 41. Die Isolationsüberwachungseinrichtung 51 ist dazu ausgebildet, ein an einem Schutzleiter anliegendes Potential zu erkennen und/oder einen elektrischen Widerstand zwischen einem Lastkontakt und dem Schutzleiter zu messen.

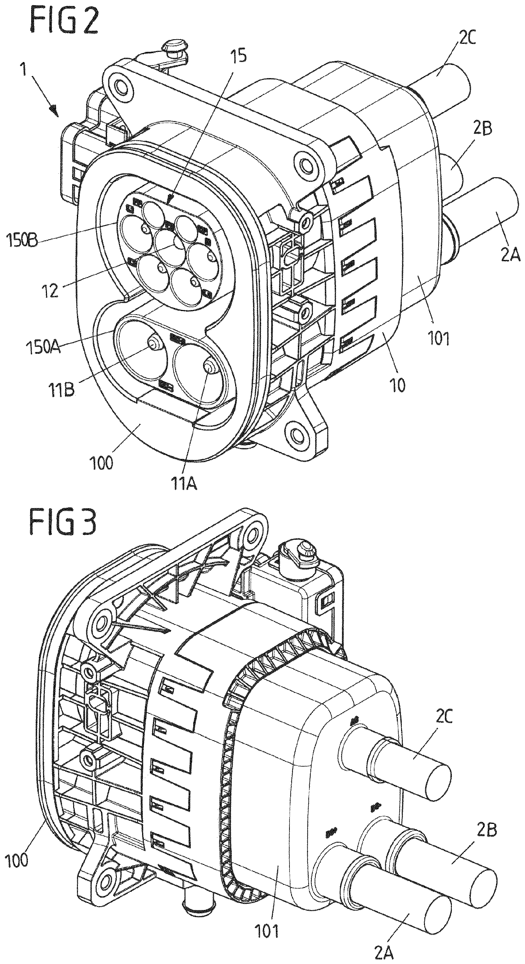

Die Isolationsüberwachungseinrichtung 41 des Fahrzeugs 4 und/oder die Isolationsüberwachungseinrichtung 51 der Ladesäule 5 kann/können erkennen, wenn ein oder mehrere Lastkontakte (insbesondere der in Fig. 2 gezeigten Lastkontakte 11A, 11B) nicht mehr ausreichend elektrisch isoliert sind, z.B. durch in das Steckverbinderteil 1 eingedrungene Feuchtigkeit.

Die Ladeeinrichtung 40 des Fahrzeugs 4 und/oder die Ladeeinrichtung 50 der Ladestation 5 kann/können dazu ausgebildet sein, vor Beginn eines Ladevorgangs des Fahrzeugs 4 (oder allgemein vor dem Einleiten einer Energieübertragung zwischen dem Fahrzeug 4 und der Ladestation 5) die Isolation der Lastkontakte (insbesondere der in Fig. 2 gezeigten Lastkontakte 11A, 11B) mittels der Isolationsüberwachungseinrichtung 41 des Fahrzeugs 4 und/oder die Isolationsüberwachungseinrichtung 51 der Ladesäule 5 zu prüfen (z.B. durch Vergleich eines Messwerts eines Potentials oder eines elektrischen Widerstands mit einem vorbestimmten Schwellenwert). Die Ladeeinrichtung 40 des Fahrzeugs 4 und/oder die Ladeeinrichtung 50 der Ladestation 5 kann/können ferner dazu ausgebildet sein, nur dann den Ladevorgang (allgemein die Energieübertragung) einzuleiten, wenn bei der Prüfung ermittelt worden ist, dass die Isolation intakt ist, und den Ladevorgang (die Energieübertragung) nicht einzuleiten oder abzubrechen, wenn bei der Prüfung ermittelt worden ist, dass die Isolation nicht intakt ist.

Fig. 2 und 3 zeigen das Steckverbinderteil 1. Das Steckverbinderteil 1 ist vorliegend zur Montage am Fahrzeug 4 ausgebildet, konkret als Fahrzeug-Inlet, z.B. gemäß dem CCS (Combined Charging System) Typ 2.

Das Steckverbinderteil 1 ist dazu ausgebildet, einen Ladestrom in Form eines Gleichstroms und/oder in Form eines Wechselstroms zu übertragen.

Das Steckverbinderteil 1 umfasst ein Gehäuse 10. Das Gehäuse 10 umschließt einen Innenraum. Vorliegend umfasst das Gehäuse 10 mehrere Gehäuseteile 100, 101. Am Gehäuse 10 ist ein Steckkörper 15 montiert, der gemeinsam mit dem Gehäuse 10 den Innenraum definiert und insbesondere gegenüber Umwelteinflüssen abdichtet, z.B. gegenüber Feuchtigkeit.

Der Steckkörper 15 bildet zumindest einen Steckabschnitt, vorliegend zwei Steckabschnitte 150A, 150B aus. Die Steckabschnitte 150A, 150B sind dazu ausgebildet, mit entsprechenden Steckabschnitten des Gegensteckverbinderteils 3 zur elektrischen Kontaktierung in Eingriff gebracht zu werden. Dabei dienen zwei Lastkontakte 11A, 11B in Form von Steckkontakten (an dem einen Steckabschnitt 150A) zum Aufbau eines Gleichstromstromkreises. Die Lastkontakte 11A, 11B sind Hochstrom-Lastkontakte. Sie können während, insbesondere für die Dauer eines Ladevorgangs oder Entladevorgangs Ströme von 50 A oder mehr, insbesondere 100 A oder mehr leiten. Weitere Steckkontakte sind an dem anderen Steckabschnitt 150B angeordnet. Das Steckverbinderteil 1 umfasst insbesondere einen Schutzleiterkontakt 12, der vorliegend an jenem Steckabschnitt 150B angeordnet ist. Weitere (optionale) Steckkontakte dienen z.B. als Wechsel- oder Drehstromkontakte oder als Datenverbindungen.

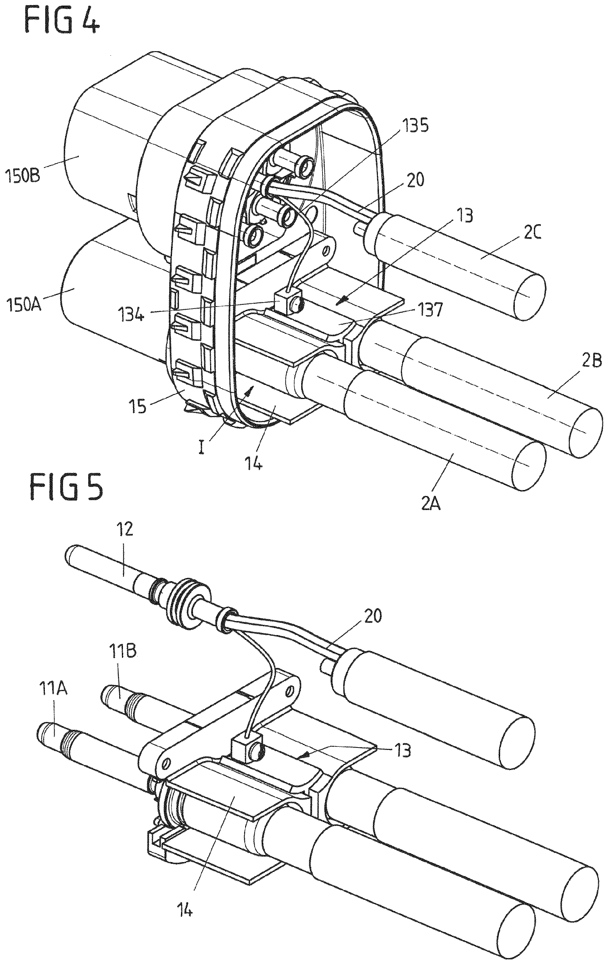

Ferner umfasst das Steckverbinderteil 1 ein in den Figuren 4 bis 13 gezeigtes und nachfolgend noch näher beschriebenes Erdungselement 13, das im Gehäuse 10 angeordnet ist und elektrisch mit dem Schutzleiterkontakt 12 verbunden ist, wobei sich das Erdungselement 13 elektrisch kontaktierbar an einem Kriechpfad zwischen den beiden Lastkontakten 11A, 11B erstreckt.

Es sei darauf hingewiesen, dass ein entsprechend angeordnetes Erdungselement gleichermaßen alternativ oder zusätzlich im Gegensteckverbinderteil 3 vorgesehen sein kann.

Zum Anschluss an die Ladeeinrichtung 40 und/oder an die Isolationsüberwachungseinrichtung 41 sind Kabel 2A-2C an das Steckverbinderteil 1 angeschlossen. Jeweils eines der Kabel 2A-2C dient zum Anschluss an einen der beiden Lastkontakte 11A, 11B. Ein weiteres Kabel 2C führt einen mit dem Schutzleiterkontakt 12 elektrisch verbundenen Schutzleiter 20. Gemeinsam mit den Kabeln 2 bildet das Steckverbinderteil 1 eine Steckverbinderanordnung. Optional sind einige der Kabel 2A-2C zu einem Kabelbündel zusammengefasst.

Fig. 4 zeigt das Steckverbinderteil 1 ohne Gehäuse 10, sodass ein Teil des durch das Gehäuse 10 und den Steckkörper 15 definierten Innenraumes I des Steckverbinderteils 1 erkennbar ist. Im Innenraum I ist das Erdungselement 13 angeordnet, welches einen elektrisch leitfähigen, z.B. metallischen Körper 137 umfasst. Der Körper 137 ist elektrisch mit dem Schutzleiterkontakt 12 verbunden. Vorliegend ist der Körper 137 über ein Kabel 135 mit einem an den Schutzleiterkontakt 12 angeschlossenen Anschluss verbunden, mit der auch ein Schutzleiter 20 des Kabels 2C elektrisch verbunden ist. Im gezeigten Beispiel ist das Kabel 135 über eine Schraubklemme 134 mit dem Körper 137 elektrisch verbunden. Die Schraubklemme 134 ist am Körper 137 angeordnet, insbesondere fest damit verbunden, z.B. daran angeschweißt.

Ferner ist im Innenraum I ein Kontaktträger 14 angeordnet. Am Kontaktträger 14 sind die Lastkontakte 11A, 11B befestigt. Der Kontaktträger 14 ist fest mit dem Steckkörper 15 verbunden, z.B. damit verschraubt.

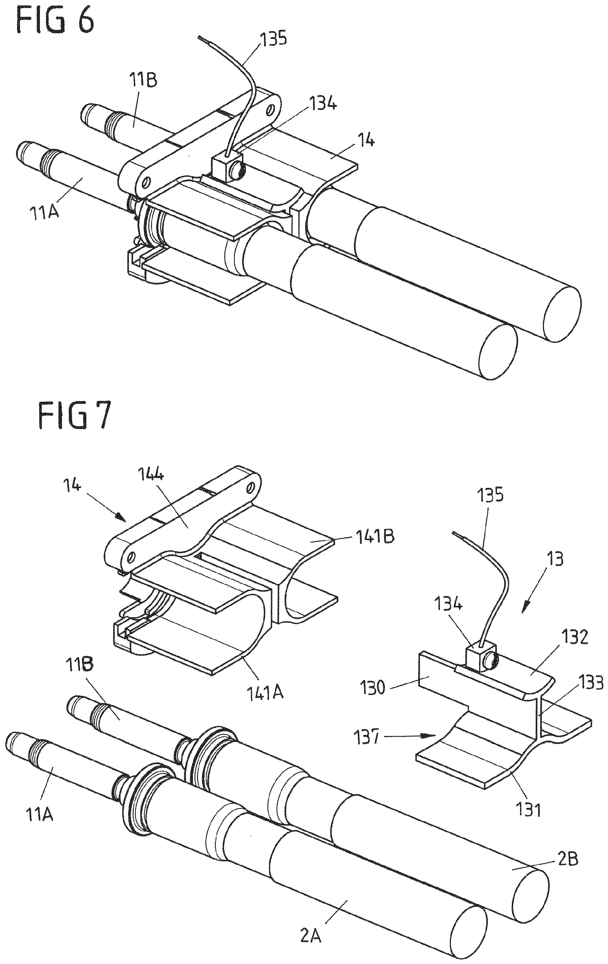

Wie z.B. anhand der Fig. 5 und 6 ersichtlich, stehen der Kontaktträger 14 und das Erdungselement 13 miteinander in Eingriff.

Dabei ist ein insbesondere in Fig. 7 gezeigter Zentralabschnitt 133 (im Allgemeinen: ein Abschnitt) des Erdungselements 13 zwischen zwei Schirmabschnitten 141A, 141B (im Allgemeinen: Abschnitten) des Kontaktträgers 14 angeordnet. Die Schirmabschnitte 141A, 141B des Kontaktträgers 14 weisen jeweils einen U-förmigen Querschnitt auf. Im montierten Zustand wird jeweils eines der Kabel 2A, 2B durch jeweils einen der Schirmabschnitte 141A, 141B teilweise umgriffen. Die Schirmabschnitte 141A, 141B weisen jeweils eine Öffnung auf, wobei die Öffnungen der Schirmabschnitte 141A, 141B (insbesondere im Querschnitt betrachtet) von einander abgewandt sind. Die Schirmabschnitte 141A, 141B dienen insbesondere zur elektrischen Isolation des darin aufgenommenen Lastkontakts 11A, 11B vom jeweils anderen Lastkontakt 11A, 11B.

Die Schirmabschnitte 141A, 141B stehen von einem Montageabschnitt 144 ab. Der Montageabschnitt 144 dient zur Montage des Kontaktträgers 14 am Steckkörper 15.

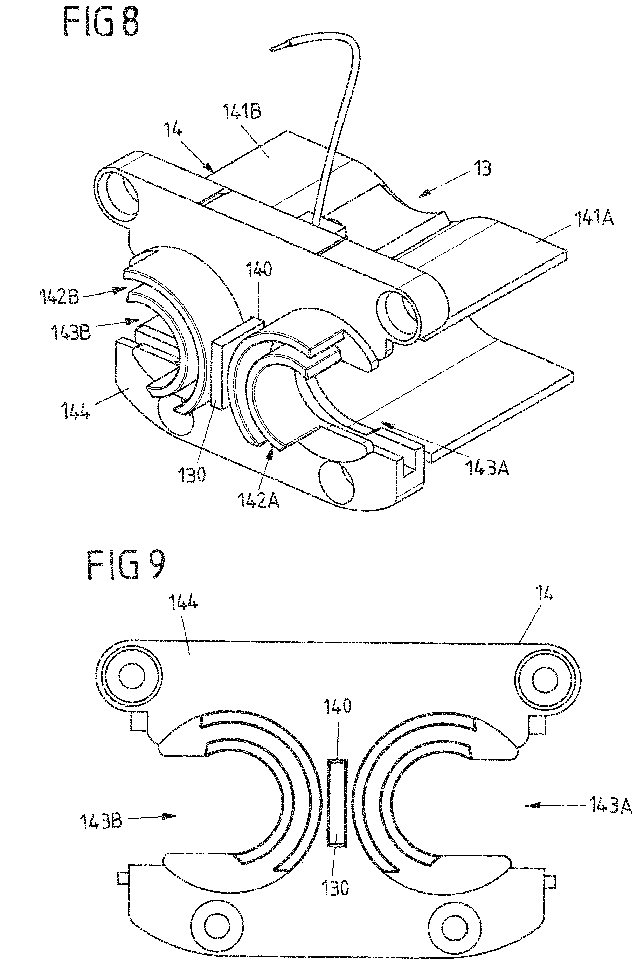

Der Montageabschnitt 144 bildet gemeinsam mit jedem der Schirmabschnitte 141A, 141B eine Aufnahme 143A, 143B für jeweils einen der Lastkontakte 11A, 11B aus, siehe insbesondere Fig. 8 und 9. Dabei ist jeder der Lastkontakte 11A, 11B in eine der beiden Aufnahmen 143A, 143B einsetzbar und zwar vorliegend aus entgegengesetzten Richtungen kommend. Die Lastkontakte 11A, 11B weisen jeweils einen Bund auf. Der jeweilige Bund ist jeweils in eine entsprechende Vertiefung (im gezeigten Beispiel am Montageabschnitt 144 und vorliegend in Form jeweils einer umlaufenden Nut) an der entsprechenden Aufnahme 143A, 143B einsetzbar, um jeden der Lastkontakte 11A, 11B axial zu sichern.

Das Erdungselement umfasst einen unteren Flügelabschnitt 131 und einen oberen Flügelabschnitt 132. Die Flügelabschnitte 131, 132 sind an gegenüberliegenden Seiten des Zentralabschnitts 133 angeordnet. Die Flügelabschnitte 131, 132 stehen jeweils beidseitig vom Zentralabschnitt 133 ab, und zwar vorliegend derart, dass sie gemeinsam die Schirmabschnitte 141A, 141B teilweise umgreifen. Der bei bestimmungsgemäßer Benutzung des Steckverbinderteils 1 unterhalb des oberen Flügelabschnitts 132 angeordnete untere Flügelabschnitt 131 ist größer als der obere Flügelabschnitt 132.

Insbesondere aus der Zusammenschau der Fig. 6 und 7 ist ersichtlich, dass ein Teil des Erdungselements 13, vorliegend der untere Flügelabschnitt 131, im bestimmungsgemäßen Gebrauch unterhalb der Lastkontakte 11A, 11B angeordnet ist. Hierdurch kann besonders zuverlässig und frühzeitig eine sich unten im Gehäuse 10 sammelnde Feuchtigkeit erkannt werden.

Das Erdungselement 13 umfasst ferner einen vorstehenden Abschnitt 130, der im gezeigten Beispiel in Form eines Messers ausgebildet ist. Der vorstehende Abschnitt 130 steht vom Zentralabschnitt 133 ab und stellt im gezeigten Beispiel eine Verlängerung des Zentralabschnitts 133 dar, die gegenüber den Flügelabschnitten 131, 132 vorsteht. Vorliegend ist der vorstehende Abschnitt 130 flach und eben.

Wie insbesondere anhand der Fig. 8 und 9 veranschaulicht, durchgreift der vorstehende Abschnitt 130 im montierten Zustand eine Öffnung 140 im Kontaktträger 14, vorliegend im Montageabschnitt 144 des Kontaktträgers 14. Im gezeigten Beispiel durchgreift der vorstehende Abschnitt 130 die Öffnung 140 in Bezug auf die (zueinander parallele) Ausrichtung der Lastkontakte 11A, 11B in axialer Richtung. Der vorstehende Abschnitt 130 ist zwischen den beiden Aufnahmen 143A, 143B des Kontaktträgers 14 für die Lastkontakte 11A, 11B angeordnet. Im montierten Zustand ist der vorstehende Abschnitt 130 zwischen den beiden Lastkontakten 11A, 11B angeordnet.

Beiderseits des vorstehenden Abschnitts 130 des Erdungselements 13 weist der Kontaktträger 14 jeweils eine Isolationskontur 142A, 142B auf. Die Isolationskonturen 142A, 142B weisen jeweils zwei koaxial zueinander angeordnete Segmente von Kreiszylindern mit unterschiedlichen Radien auf. Diese Segmente sind so angeordnet, dass sich darin in der bestimmungsgemäßen Benutzung kein Wasser sammeln kann, wozu sie vorliegend seitlich und nach unten geöffnet sind. Die Segmente bilden jeweils einen Teil der jeweiligen Aufnahme 143A, 143B. Die Isolationskonturen 142A, 142B dienen dazu, einen Kriechpfad zwischen den beiden Lastkontakten 11A, 11B, entlang dem durch eingedrungene Feuchtigkeit eine elektrische Verbindung zwischen den Lastkontakten 11A, 11B hergestellt werden könnte, zu verlängern. Der vorstehende Abschnitt 130 des Erdungselements 13 ist auf diesem Kriechpfad angeordnet. Hierdurch kann (z.B. mittels einer der Isolationsüberwachungseinrichtungen 41, 51) eine defekte Isolierung zwischen den beiden Lastkontakten 11A, 11B sicher erkannt werden.

Die Isolationskonturen 142A, 142B stehen vom Montageabschnitt 144 ab, konkret an einer den Schirmabschnitten 141A, 141B gegenüberliegenden Seite.

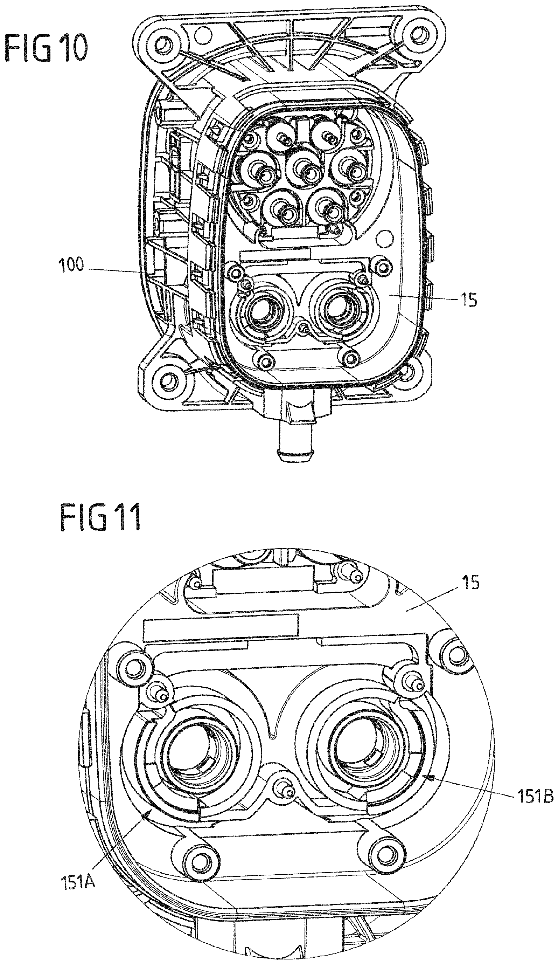

Fig. 10 und 11 zeigen insbesondere, dass der Steckkörper 15 Isolationskonturen 151A, 151B aufweist. Die Isolationskonturen 151A, 151B sind passend zu den Isolationskonturen 142A, 142B des Kontaktträgers 14 ausgebildet, sodass sie damit in Eingriff gebracht werden können und im montierten Zustand stehen.

Anhand von Fig. 10 sowie z.B. von Fig. 2 lässt sich ferner erkennen, dass bei dem Steckverbinderteil 1 die (Gleichstrom-) Lastkontakte 11A, 11B näher zueinander angeordnet sind als jeder der Lastkontakte 11A, 11B zum Schutzleiterkontakt 12. Ferner sind die Lastkontakte 11A, 11B (im Gebrauch) unterhalb des Schutzleiterkontakts 12 angeordnet.

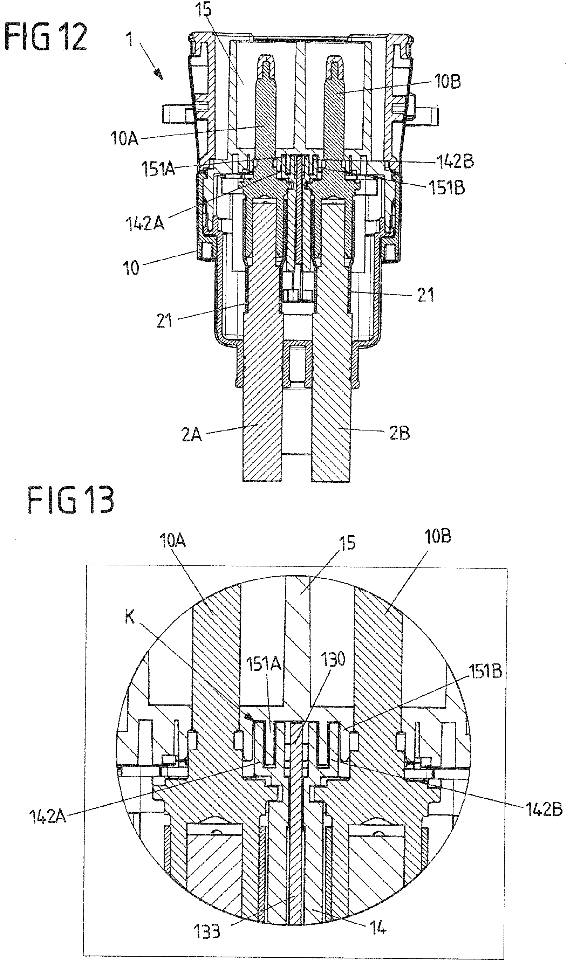

Fig. 12 und 13 zeigen in der Querschnittsansicht den montierten Zustand des Steckverbinderteils 1. Dabei ist insbesondere zu erkennen, dass die Isolationskonturen 142A, 142B, 151A, 151B des Kontaktträgers 14 und des Steckkörpers 15 miteinander in Eingriff stehen, und zwar vorliegend insbesondere in einem Bereich zwischen den beiden Lastkontakten 11A, 11B. Dabei bildet sich eine Art mäanderförmiger Verlauf.

Ferner ist veranschaulicht, dass sich der vorstehende Abschnitt 130 zwischen den jeweils in Eingriff stehenden Isolationskonturen 142A, 142B, 151A, 151B des Kontaktträgers 14 und des Steckkörpers 15 erstreckt.

Innerhalb des jeweiligen Schirmabschnitts 141A, 141B (und darüber hinaus) ist jeder der Lastkontakte 11A, 11B sowie ein daran angeschlossener Leiter des jeweiligen Kabels 2A, 2B von einer Hülle 21 umschlossen, die z.B. aus einem Isoliermaterial hergestellt ist.

Trotz des mäanderförmigen Verlaufs durch die in Eingriff stehenden Isolationskonturen 142A, 142B, 151A, 151B des Kontaktträgers 14 und des Steckkörpers 15 verläuft der kürzeste Kriechpfad K zwischen den Lastkontakten 11A, 11B zwischen dem Kontaktträger 14 (vorliegend dem Montageabschnitt 144 des Kontaktträgers 14) und dem Steckkörper 15. Insbesondere in Fig. 13 ist zu erkennen, dass das Erdungselement 13, insbesondere der vorstehende Abschnitt 130 des Erdungselements 13, auf dem kürzesten Kriechpfad K angeordnet ist. Hierdurch kann besonders zuverlässig eine mangelnde Isolation erkannt werden.

Der Körper 137 des Erdungselements 13 besteht z.B. aus Metall oder einem anderen elektrisch leitfähigen Material und ist durch Berührung (an beliebiger Stelle), z.B. durch Wasser, elektrisch kontaktierbar. Der Körper 137 des Erdungselements 13 ist vorliegend einteilig ausgebildet, kann alternativ aber auch mehrteilig ausgebildet sein.

Optional dient das Erdungselement 13 auch als Kühlkörper. Beispielsweise wird es mit einem Kühlmittel beaufschlagt, z.B. dadurch durchströmt.

Es sei nochmals verdeutlicht, dass das wie beschrieben ausgebildete und angeordnete Erdungselement 13 in gleicher Wirkweise sowohl in Fahrzeugladedosen, als auch in Ladesteckern an Ladesäulen einsetzbar ist.

### Bezugszeichenliste

- 1: Steckverbinderteil
- 10: Gehäuse
- 100, 101: Gehäuseteil
- 11A, 11B: Lastkontakt
- 12: Schutzleiterkontakt
- 13: Erdungselement
- 130: vorstehender Abschnitt (Messer)
- 131: unterer Flügelabschnitt
- 132: oberer Flügelabschnitt
- 133: Zentralabschnitt
- 134: Schraubklemme
- 135: Kabel
- 137: Körper
- 14: Kontaktträger
- 140: Öffnung
- 141A, 141B: Schirmabschnitt
- 142A, 142B: Isolationskontur
- 143A, 143B: Aufnahme
- 144: Montageabschnitt
- 15: Steckkörper
- 150A, 150B: Steckabschnitt
- 151A, 151B: Isolationskontur
- 2A-2C: Kabel
- 20: Schutzleiter
- 21: Hülle
- 3: Gegensteckverbinderteil
- 4: Fahrzeug
- 40: Ladeeinrichtung
- 41: Isolationsüberwachungseinrichtung
- 5: Ladestation
- 50: Ladeeinrichtung
- 51: Isolationsüberwachungseinrichtung
- 52: Kabel
- I: Innenraum
- K: Kriechpfad

## Patentansprüche

1. Steckverbinderteil (1) zur elektrischen Verbindung mit einem Gegensteckverbinderteil (3), mit
- einem Gehäuse (10),
- zumindest zwei Lastkontakten (11A, 11B),
- einem elektrisch isolierenden Kontaktträger (14), durch den die Lastkontakte (11A, 11B) am Gehäuse (10) gehalten sind,
- einem Schutzleiterkontakt (12) und
- einem Erdungselement (13), das im Gehäuse (10) angeordnet und elektrisch mit dem Schutzleiterkontakt (12) verbunden ist,
wobei sich das Erdungselement (13) elektrisch kontaktierbar an einem Kriechpfad (K) zwischen den beiden Lastkontakten (11A, 11B) erstreckt,
**dadurch gekennzeichnet, dass** das Erdungselement (13) ein Messer (130) umfasst, das eine Öffnung (140) im Kontaktträger (14) durchgreift.

2. Steckverbinderteil (1) nach Anspruch 1, **dadurch gekennzeichnet, dass** sich das Erdungselement (13) elektrisch kontaktierbar an dem kürzesten Kriechpfad (K) zwischen den beiden Lastkontakten (11A, 11B) erstreckt.

3. Steckverbinderteil (1) nach Anspruch 1 oder 2, **dadurch gekennzeichnet, dass** sich das Erdungselement (13) zwischen den Lastkontakten (11A, 11B) erstreckt.

4. Steckverbinderteil (1) nach einem der Ansprüche 1 bis 3, **dadurch gekennzeichnet, dass** der Kontaktträger (14) für jeden der Lastkontakte (11A, 11B) eine Isolationskontur (142A, 142B) aufweist, wobei sich das Messer (130) des Erdungselements (13) zumindest abschnittsweise zwischen den Isolationskonturen (142A, 142B) erstreckt.

5. Steckverbinderteil (1) nach Anspruch 4, **gekennzeichnet durch** einen Steckkörper (15), der für jeden der Lastkontakte (11A, 11B) eine Isolationskontur (151A, 151B) aufweist, die mit der Isolationskontur (142A, 142B) des Kontaktträgers (14) für den jeweiligen Lastkontakt (11A, 11B) in Eingriff steht.

6. Steckverbinderteil (1) nach einem der Ansprüche 1 bis 5, **dadurch gekennzeichnet, dass** der Kontaktträger (14) für jeden Lastkontakt (11A, 11B) einen Schirmabschnitt (141A, 141B) zur elektrischen Isolation vom jeweils anderen Lastkontakt (11A, 11B) aufweist.

7. Steckverbinderteil (1) nach Anspruch 6, **dadurch gekennzeichnet, dass** sich das Erdungselement (13) zwischen den Schirmabschnitten (141A, 141B) und zumindest teilweise um die Schirmabschnitte (141A, 141B) herum erstreckt.

8. Steckverbinderteil (1) nach einem der vorhergehenden Ansprüche, **dadurch gekennzeichnet, dass** sich zumindest ein Teil des Erdungselements (13) bei einer bestimmungsgemäßen Verbindung des Steckverbinderteils (1) mit dem Gegensteckverbinderteil (3) an einer weiter unten gelegenen Stelle erstreckt als die Lastkontakte (11A, 11B).

9. Steckverbinderteil (1) nach einem der vorhergehenden Ansprüche, **dadurch gekennzeichnet, dass** das Erdungselement (13) einen metallischen Körper (137) umfasst.

10. Steckverbinderteil (1) nach Anspruch 9, **dadurch gekennzeichnet, dass** der metallische Körper (137) über ein Kabel (135) mit dem Schutzleiterkontakt (12) elektrisch verbunden ist.

11. Steckverbinderteil (1) nach einem der vorhergehenden Ansprüche, **dadurch gekennzeichnet, dass** das Steckverbinderteil (1) dazu ausgebildet ist, eine elektrische Leistung von 10 kW oder mehr zu leiten.

12. Steckverbinderteil (1) nach einem der vorhergehenden Ansprüche, **dadurch gekennzeichnet, dass** das Steckverbinderteil (1) als Fahrzeugladestecker zum Gleichstrom-Hochstromladen ausgebildet ist.

13. Ladeanordnung zum Be- und/oder Entladen eines Elektrofahrzeugs (4), **gekennzeichnet durch** das Steckverbinderteil (1) nach einem der vorhergehenden Ansprüche und eine elektrisch mit dem Schutzleiterkontakt (12) des Steckverbinderteils (1) verbundene oder verbindbare Isolationsüberwachungseinrichtung (41), die dazu eingerichtet ist, eine am Schutzleiterkontakt (12) anliegende elektrische Spannung gegenüber einem Erdpotential zu erfassen.

14. Elektrofahrzeug (4), **gekennzeichnet durch** ein Steckverbinderteil (1) nach einem der Ansprüche 1 bis 12 oder durch eine Ladeanordnung nach Anspruch 13.

## Claims

1. Plug-in connector part (1) for electrical connection to a mating plug-in connector part (3), comprising
- a housing (10),
- at least two load contacts (11A, 11B),
- an electrically insulating contact carrier (14) by which the load contacts (11A, 11B) are held on the housing (10),
- a protective conductor contact (12) and
- an earthing element (13) which is arranged in the housing (10) and is electrically connected to the protective conductor contact (12),
wherein the earthing element (13) extends in an electrically contactable manner on a creep path (K) between the two load contacts (11A, 11B),
**characterized in that** the earthing element (13) comprises a blade (130) which passes through an opening (140) in the contact carrier (14).

2. Plug-in connector part (1) according to Claim 1, **characterized in that** the earthing element (13) extends in an electrically contactable manner on the shortest creep path (K) between the two load contacts (11A, 11B).

3. Plug-in connector part (1) according to Claim 1 or 2, **characterized in that** the earthing element (13) extends between the load contacts (11A, 11B).

4. Plug-in connector part (1) according to any of Claims 1 to 3, **characterized in that** the contact carrier (14) has an insulation contour (142A, 142B) for each of the load contacts (11A, 11B), wherein the blade (130) of the earthing element (13), at least in portions, extends between the insulation contours (142A, 142B).

5. Plug-in connector part (1) according to Claim 4, **characterized by** a plug-in body (15) which has an insulation contour (151A, 151B) for each of the load contacts (11A, 11B), the insulation contour engaging with the insulation contour (142A, 142B) of the contact carrier (14) for the respective load contact (11A, 11B).

6. Plug-in connector part (1) according to any of Claims 1 to 5, **characterized in that** the contact carrier (14) has, for each load contact (11A, 11B), a shielding portion (141A, 141B) for electrical insulation from the respectively other load contact (11A, 11B).

7. Plug-in connector part (1) according to Claim 6, **characterized in that** the earthing element (13) extends between the shielding portions (141A, 141B) and at least partially around the shielding portions (141A, 141B).

8. Plug-in connector part (1) according to any of the preceding claims, **characterized in that** at least part of the earthing element (13) extends to a point further down than the load contacts (11A, 11B) when the plug-in connector part (1) is connected to the mating plug-in connector part (3) as intended.

9. Plug-in connector part (1) according to any of the preceding claims, **characterized in that** the earthing element (13) comprises a metal body (137).

10. Plug-in connector part (1) according to Claim 9, **characterized in that** the metal body (137) is electrically connected to the protective conductor contact (12) via a cable (135).

11. Plug-in connector part (1) according to any of the preceding claims, **characterized in that** the plug-in connector part (1) is designed to conduct an electrical power of 10 kW or more.

12. Plug-in connector part (1) according to any of the preceding claims, **characterized in that** the plug-in connector part (1) is designed as a vehicle charging plug for DC high-current charging.

13. Charging arrangement for charging and/or discharging an electric vehicle (4), **characterized by** the plug-in connector part (1) according to any of the preceding claims and an insulation monitoring device (41) which is electrically connected or connectable to the protective conductor contact (12) of the plug-in connector part (1) and is configured to detect a electrical voltage applied to the protective conductor contact (12) in relation to an earth potential.

14. Electric vehicle (4), **characterized by** a plug-in connector part (1) according to any of Claims 1 to 12 or by a charging arrangement according to Claim 13.

## Revendications

1. Partie de connecteur à enficher (1) destinée à la connexion électrique avec une partie de connecteur à enficher homologue (3), comprenant
- un boîtier (10),
- au moins deux contacts de charge (11A, 11B),
- un porte-contacts (14) électriquement isolant, par lequel les contacts de charge (11A, 11B) sont maintenus au boîtier (10),
- un contact de conducteur de protection (12) et
- un élément de mise à la terre (13), qui est disposé dans le boîtier (10) et relié électriquement au contact de conducteur de protection (12),
l'élément de mise à la terre (13) s'étendant de manière à pouvoir être mis en contact électrique au niveau d'un chemin de courant de fuite (K) entre les deux contacts de charge (11A, 11B),
**caractérisée en ce que** l'élément de mise à la terre (13) comporte une lame (130) qui traverse une ouverture (140) dans le porte-contacts (14).

2. Partie de connecteur à enficher (1) selon la revendication 1, **caractérisée en ce que** l'élément de mise à la terre (13) s'étend de manière à pouvoir être mis en contact électrique au niveau du chemin de courant de fuite le plus court (K) entre les deux contacts de charge (11A, 11B).

3. Partie de connecteur à enficher (1) selon la revendication 1 ou 2, **caractérisée en ce que** l'élément de mise à la terre (13) s'étend entre les deux contacts de charge (11A, 11B).

4. Partie de connecteur à enficher (1) selon l'une des revendications 1 à 3, **caractérisée en ce que** le porte-contacts (14) possède un contour d'isolation (142A, 142B) pour chacun des contacts de charge (11A, 11B), la lame (130) de l'élément de mise à la terre (13) s'étendant au moins par certaines portions entre les contours d'isolation (142A, 142B).

5. Partie de connecteur à enficher (1) selon la revendication 4, **caractérisée par** un corps à enficher (15) qui, pour chacun des contacts de charge (11A, 11B), possède un contour d'isolation (151A, 151B), lequel est en prise avec le contour d'isolation (142A, 142B) du porte-contacts (14) pour le contact de charge (11A, 11B) respectif.

6. Partie de connecteur à enficher (1) selon l'une des revendications 1 à 5, **caractérisée en ce que** le porte-contacts (14) possède, pour chaque contact de charge (11A, 11B), une portion de blindage (141A, 141B) destinée à l'isolation électrique de l'autre contact de charge (11A, 11B) respectif.

7. Partie de connecteur à enficher (1) selon la revendication 6, **caractérisée en ce que** l'élément de mise à la terre (13) s'étend entre les portions de blindage (141A, 141B) et au moins partiellement autour des portions de blindage (141A, 141B).

8. Partie de connecteur à enficher (1) selon l'une des revendications précédentes, **caractérisée en ce qu'**au moins une partie de l'élément de mise à la terre (13), dans le cas d'une utilisation de la partie de connecteur à enficher (1) avec la partie de connecteur à enficher homologue (3) conformément à sa destination, s'étend au niveau d'un endroit situé plus bas que les contacts de charge (11A, 11B).

9. Partie de connecteur à enficher (1) selon l'une des revendications précédentes, **caractérisée en ce que** l'élément de mise à la terre (13) comporte un corps métallique (137).

10. Partie de connecteur à enficher (1) selon la revendication 9, **caractérisée en ce que** le corps métallique (137) est relié électriquement au contact de conducteur de protection (12) par le biais d'un câble (135) .

11. Partie de connecteur à enficher (1) selon l'une des revendications précédentes, **caractérisée en ce que** la partie de connecteur à enficher (1) est configurée pour conduire une puissance électrique de 10 kW ou plus.

12. Partie de connecteur à enficher (1) selon l'une des revendications précédentes, **caractérisée en ce que** la partie de connecteur à enficher (1) est réalisée sous la forme d'une fiche de charge de véhicule destinée à la charge à courant fort en courant continu.

13. Arrangement de charge destiné à charger et/ou décharger un véhicule électrique (4), **caractérisé par** la partie de connecteur à enficher (1) selon l'une des revendications précédentes et un dispositif de surveillance d'isolation (41), relié ou pouvant être relié au contact de conducteur de protection (12) de la partie de connecteur à enficher (1), lequel est conçu pour détecter une tension électrique appliquée au contact de conducteur de protection (12) par rapport à un potentiel de terre.

14. Véhicule électrique (4), **caractérisé par** une partie de connecteur à enficher (1) selon l'une des revendications 1 à 12 ou par un arrangement de charge selon la revendication 13.
